# EUROPEAN PATENT SPECIFICATION

(11) **EP 1 931 183 B1**
(45) Date of publication and mention of the grant of the patent: **06.11.2013**
(21) Application number: 07023165.9
(22) Date of filing: 29.11.2007
(51) Int. Cl.: H05K 1/14, H05K 3/32, H05K 1/05, H05K 3/36, H05K 3/34, H05K 3/40

(54) **Electronic device**
Elektronische Vorrichtung
Dispositif électronique

(30) Priority: 04.12.2006 JP 2006327296
(43) Date of publication of application: 11.06.2008
(73) Proprietor: Hitachi, Ltd., Chiyoda-ku Tokyo 100-8280 (JP)
(72) Inventor: Yokozuka, Takehide, Chiyoda-ku Tokyo 100-8220 (JP); Ikeda, Ukyo, Chiyoda-ku Tokyo 100-8220 (JP); Harada, Masahide, Chiyoda-ku Tokyo 100-8220 (JP); Yoshinari, Hideto, Chiyoda-ku Tokyo 100-8220 (JP)
(74) Representative: Strehl Schübel-Hopf & Partner

(56) References cited:
- US-A- 6 101 094
- US-A1- 2002 191 379
- US-B2- 6 765 805

## Description

### BACKGROUND OF THE INVENTION

### 1. Field of the Invention

The present invention relates to an electronic device as typified by a motor driver unit, a direct injection engine control unit, etc. for automobiles.

### 2. Description of the Related Art

In consideration of environmental problems, it is expected that automobiles driven by an electric motor as typified by a hybrid car will become more widely used in the future. Further, there is a strong trend toward replacing a power steering and a brake hydraulically controlled conventionally with an electronic control unit (ECU) utilizing an electric motor. A motor control ECU uses IGBT and FET chips having a large current flow and therefore generates heat of several tens to hundreds of watts. The generated heat needs to be cooled with water cooling or air cooling. Further, although it is thought that the demand for a direct injection engine control unit will increase in the future, it is necessary to treat a comparatively large current in terms of the function thereof. Each of these ECUs includes a section with a large current flow exhibiting a high heat release value, requiring enhanced heat dissipation properties, and a section with a small current flow exhibiting a low heat release value, not requiring enhanced heat dissipation properties. With many products, it is structurally advantageous to manufacture these sections as separate circuits, i.e., the former as a power module and the latter as a control module, and configure these circuits on two different substrates. For connection between the two substrates, a technique for connecting between terminal pads thereof by use of a lead frame connector can be used. In this case, solder or ultrasonic joining is mainly used to connect the lead frame connector and the pads.

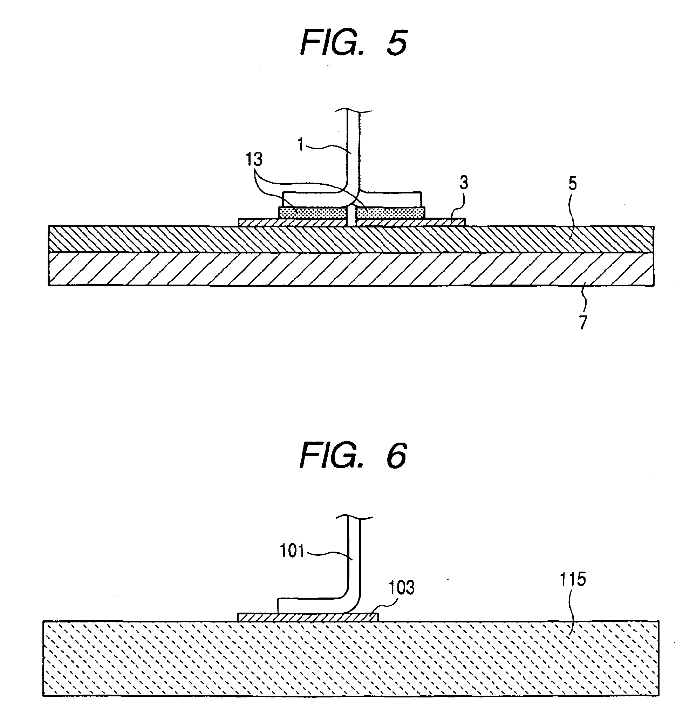

The shape of a conventional lead frame connector 101 is as shown in FIG. 6. Hereafter, a section of the lead frame connector subjected to ultrasonic joining to be connected with an electrode pad on the substrate is referred to as joint and remaining section as body. A joint formed by being folded to one side with respect to the lead frame connector body is ultrasonically joined with an electrode pad 103 on a ceramic substrate 115. Conventionally, a joint has been thus formed only on one side with respect to the body.

JP-A-2006-179312 discloses a connector pin for a camera module, which is bifurcated to be used for each of conduction with the module bottom and an external terminal, and a bifurcated pin joint is arranged only on one side in order to downsize the connector.

### SUMMARY OF THE INVENTION

Solder joining between a lead frame connector and a module is restricted in terms of many aspects of process. For example, on the premise of joining between substrates, mounting of components on each substrate is completed and therefore many components have already been mounted on the substrate by soldering. Therefore, to joint a module with a lead frame connector, it is common to take measures for partially melting solder through local heating, etc. so that a soldered joint of a mounted component does not re-melt. Therefore, if joining is performed only on one side, the joining force is weak and a soldered section of a mounted component may re-melt resulting in removal of the component and connection failure.

Further, a method of ultrasonically joining the lead frame connector and the pad has been proposed as a joining method without using solder. In the case of a ceramic substrate such as LTCC and SiC, the power of the ultrasonic wave is efficiently transmitted to the joint because of sufficient rigidity thereof, making it possible to sufficiently increase the joining strength. However, there arises a problem that the cost also increases. In order to solve this problem, a metal base substrate using resin for an insulating layer may be used. In this case, however, the insulating resin layer included in the metal base substrate absorbs the power of the ultrasonic wave, decreasing the joining strength. Therefore, sufficient joining strength cannot be obtained if joining is performed only on one side.

US 6 765 805 B2 discloses an electronic device and its manufacturing method with the features of the preamble of present claim 1. US 2002/191379 A1 and US-A-6 101 094 show other conventional examples of such a device and method.

If a joint is formed only on one side with respect to the body as shown in FIG. 6, the joint is susceptible to the effect of an external force applied from a joint at the other end. For example, if a tensile force is applied, the joint is subjected not only to the tensile force but also to a moment force around the center thereof, which makes the joint easily remove. If such an external force that the relative position of two substrates is changed, for example, rapid temperature change or impact is applied, the joint may be destroyed. This destruction may occur not only during operation as a product but also during reliability acceleration test before shipment, for example, heat cycle test, impact test, etc.

In order to solve the object of improved reliability, the present invention comprises the features defined in claim 1. The subclaims relate to preferred embodiments.

In accordance with the present invention, there can be provided an electronic device having sufficient reliability on lead connection, and particularly an electronic device having sufficient joining strength without damaging the resin even when the lead frame connector is ultrasonically joined with a substrate using resin such as a metal base substrate.

### BRIEF DESCRIPTION OF THE DRAWINGS

FIG. 1 is a perspective view showing an example of the shape in the vicinity of a joint of a lead frame connector according to the present invention;
FIG. 2 is a sectional view showing an example of the shape in the vicinity of a joint of a lead frame connector according to the present invention;
FIG. 3 is a sectional view showing an example of the shape in the vicinity of a joint of a lead frame connector;
FIG. 4 is a diagram showing an example of the shape of an end of an oscillator tool of an ultrasonic joining apparatus which collectively connects a plurality of lead frame connectors according to the present invention;
FIG. 5 is a sectional view showing a second embodiment of an example of the shape in the vicinity of a joint of a lead frame connector according to the present invention;
FIG. 6 is a sectional view showing an example of the shape in the vicinity of a joint of a conventional lead frame connector;
FIG. 7 is a sectional view of an ECU module which is an electronic device according to the present invention; and
FIG. 8 is a perspective view showing another example of the shape in the vicinity of a joint of a lead frame connector according to the present invention.

### DETAILED DESCRIPTION OF THE PREFERRED EMBODIMENTS

Preferred embodiments for carrying out the present invention will be described below.

### First Embodiment

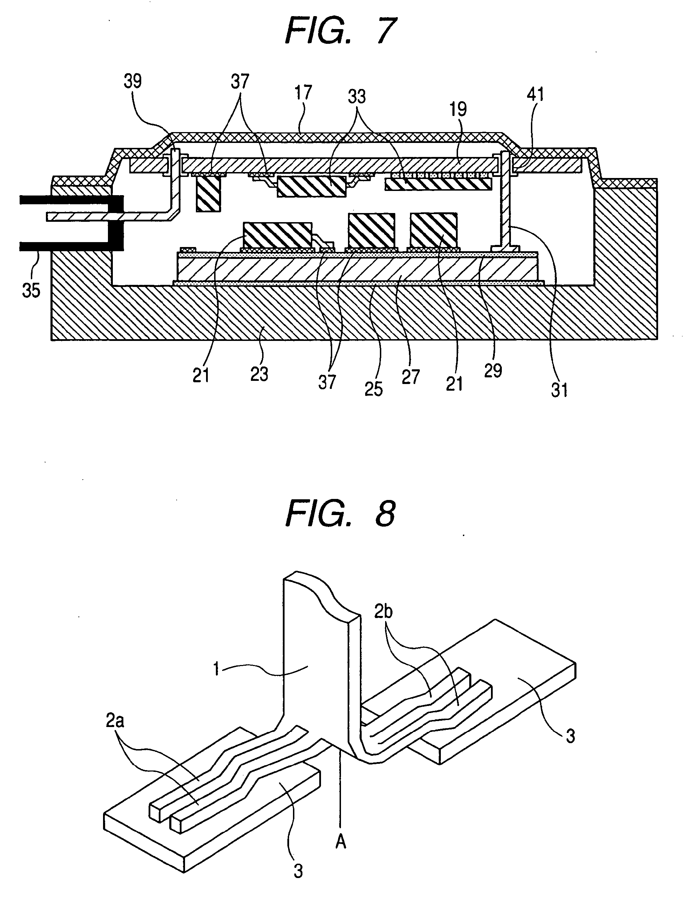

An embodiment which can realize an ECU adapted to provide sufficient reliability for use in a motor driver unit or a direct injection engine control unit for automobiles will be explained below. First, a general structure of the ECU is shown in FIG. 7. A power module has MOSFET, diode, and other high heat generation components (first components) 21 mounted thereon through electrode pads 37. A control module has a microcomputer and other low heat generation components (second components) 33 mounted thereon through electrode pads 37. The power module and the control module are arranged so that the component-mounted sides thereof face each other, connected with each other by use of a lead frame connector 31 (1), and stored in an aluminum housing 23. A metal base substrate is fixed to the aluminum housing with adhesive 25 or the like. The use of adhesive having high heat conductivity makes it possible to efficiently release heat from the metal base to the housing and further to the outside. Electrical connection with the outside is made through a connector 35 attached to a through hole 39 of the control module. The aluminum housing 23 is capped with a housing cover 17 made of aluminum and is sealed with adhesive. The cover may be sealed with screws for easier opening and closing. The power module is composed of a metal base substrate (first substrate) including an aluminum base 27 (7) (using aluminum, etc.) and an insulating resin 29 (5), and the components 21. The control module is composed of a resin substrate (printed circuit board) (second substrate) 19 and the components 33. The lead frame connector 31 (1) makes electrical connection through a through hole 41 provided in the resin substrate 19. Connection is made with soldering or press-fit connection.

Normally, circuits having a comparatively large current flow and high heat generation components are mounted on the power module. Since the power module requires high heat dissipation properties, a ceramic substrate having high thermal conductivity is normally used. However, a metal base substrate having an insulating resin layer and being capable of improving heat dissipation properties is used from the viewpoint of cost. Aluminum is used as a base metal from the viewpoint of processability and weight. The use of copper makes it possible to further improve heat dissipation properties. Further, since the coefficient of thermal expansion can be equalized with copper wiring, the warp of the substrate can be reduced. A copper foil used for ordinary printed circuit boards can be used as wiring for the substrate. Although unnecessary because of ultrasonic joining, nickel and gold plating may be applied to a pad for solder joining. In this case, although nickel and gold plating is formed also on a pad for ultrasonic joining, no problem occurs as long as joining conditions are appropriately selected.

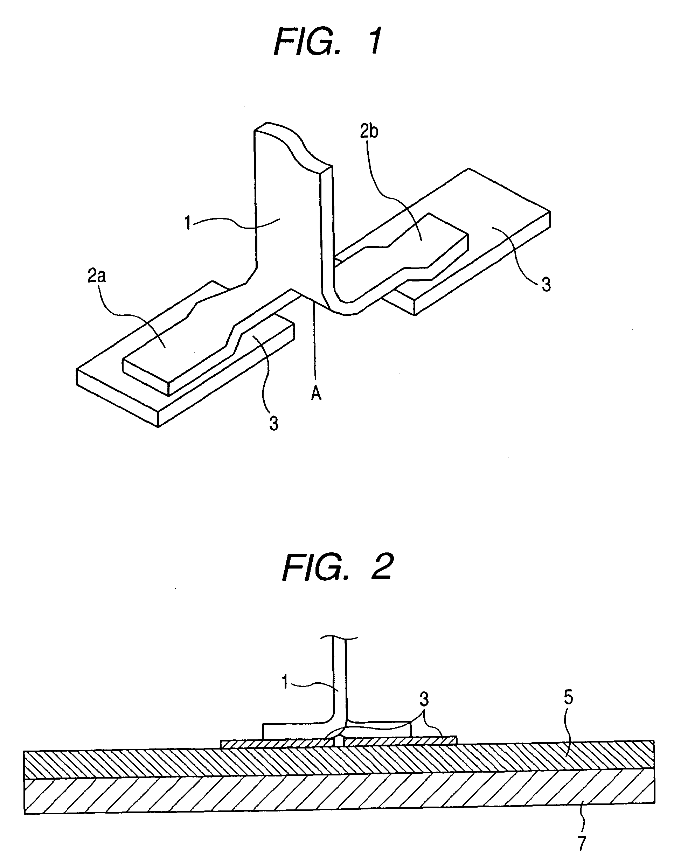

A perspective view of the lead frame connector 1 (31) in the electronic device of the present invention is shown in FIG. 1, and a sectional view thereof is FIG. 2. Copper or copper-based alloy is used as a material of the lead frame connector 1 (31). The use of aluminum can reduce the weight. Referring to FIG. 2, electrode pads 3 are provided on a substrate which is formed by an aluminum base 7 (27) and an insulating resin layer 5 (29). Hereafter, a section of the lead frame connector joined with electrode pads is referred to as joint and remaining section as body. With the lead frame connector body as center, two joint pieces 2a and 2b are formed so as to mutually protrude in opposite directions substantially perpendicularly to the body at a boundary position A between the body and the joint pieces. That is, with the lead frame connector body as center, two joint pieces are symmetrically formed substantially perpendicularly to the body to form a T shape. If an external force accompanying vibration or temperature change is applied to the lead frame connector body, the T shape makes it possible to remarkably reduce a moment force which would otherwise be generated with a lead frame connector having the conventional shape.

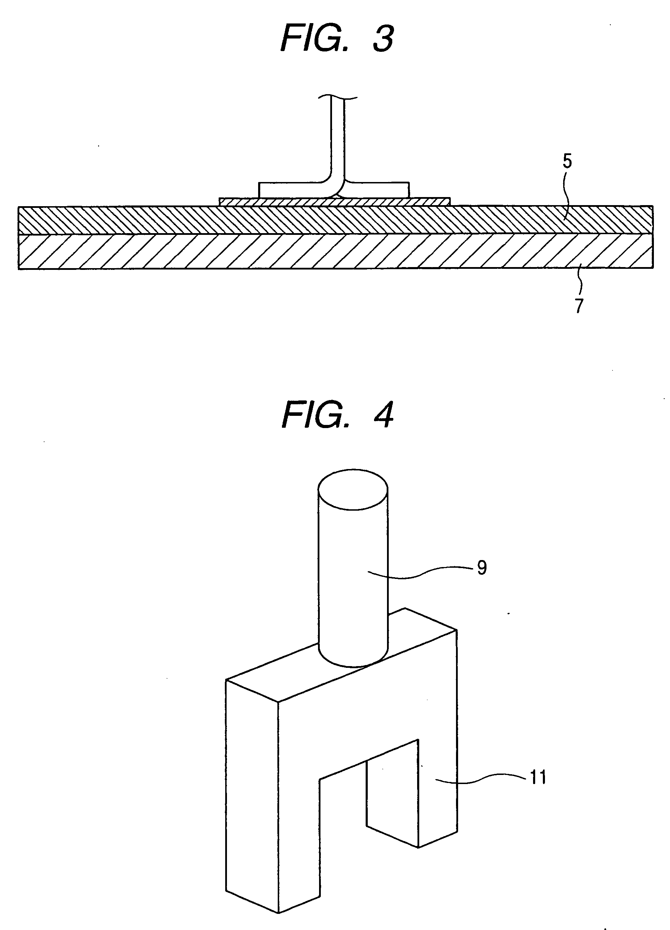

Further, as shown in FIG. 8, it may be possible to split each of the joint pieces 2a and 2b into two sub-pieces with respect to the body resulting in a total of four sub-pieces. Further, although not shown, it is clear that the same effect can be obtained also by splitting each joint piece into three sub-pieces (a total of six sub-pieces) or n sub-pieces (a total of 2n sub-pieces). With the thus split joint pieces, the joining strength increases on the rotational moment about an axis in parallel with the substrate of the lead frame connector body at each joint. Further, when ultrasonic joining is performed, the power of the ultrasonic wave is efficiently transmitted to each section making it possible to improve the total joining strength. To manufacture parts having the above-mentioned shape, die cut by press forming is low in cost. Each joint piece of the lead frame connector is positioned so as to be placed on a pad on the substrate. Since there normally is a plurality of lead frame connectors, mounting becomes easier by binding them with resin or the like. The electrode pads 3 on the substrate may be integrated into one as shown in FIG. 3, which shows an example not falling under the scope of the present claims.

In the process of joining with the substrate, for example, the end of an ultrasonic bonder oscillator is pressed on one joint piece at the time of joining, and then the end of the oscillator is pressed on the other joint piece in the same manner at the time of joining. If the end shape 11 of the oscillator 9 is devised as shown in FIG. 4, it is possible to simultaneously join two joint pieces of a lead frame connector. This technique is advantageous in reliability because, in separate joining, one joint piece joined first may be damaged when the other one is joined later.

With a resin base substrate, if the power of the ultrasonic wave is too intensive, damage is concentrated on the insulating resin layer having the lowest strength, which may cause the resin to get burned or destroyed resulting in exfoliation of wiring from the resin. Therefore, joining needs to be performed with weak power. The present invention, wherein an area per joint piece between the lead frame connector and the substrate is reduced but joining is performed at a plurality of positions, is advantageous as a method of sufficiently maintaining the joining strength while avoiding damage to the substrate.

Further, the present invention makes it possible to use a small joint area not only with a metal substrate but also with an ordinary resin substrate (printed circuit board), which is very effective to improve the mounting density. Although the use of a resin substrate for the power module is very difficult in terms of heat dissipation properties, a resin substrate is used for the control module if the control module is arranged within the same housing as that of the power module. Further, insulating resin materials having high heat conductivity made of epoxy resin with mixed filler of aluminum or silica have been developed in recent years. Accordingly, it may be possible to use a resin substrate made of such materials for the power module.

Although the power and control modules are arranged so that the component-mounted sides thereof face each other in order to reduce the capacity of the entire modular structure in many cases, it is clear that the same effect is also obtained even if these modules are laterally arranged.

### Second Embodiment

A second embodiment is shown in FIG. 5. FIG. 5 shows a sectional view showing a structure after ultrasonic joining. A lead frame connector 1 (31) made of copper is ultrasonically joined with electrode pads 3 made of copper provided on an insulating resin layer 5 (29) on a metal base 7 (27), with aluminum foils 13, having almost the same area as a joint piece, sandwiched between the lead frame connector and the electrode pads. Other configurations are the same as those of the above-mentioned first embodiment. Since joining of aluminum and copper provides better joining condition with lower power than joining of coppers, an effect of attaining higher joining strength is obtained by sandwiching an aluminum foil between the lead frame connector and the substrate when ultrasonic joining is performed.

While we have shown and described several embodiments in accordance with the present invention, it is understood that the same is not limited thereto but is susceptible of numerous changes and modifications as known to those skilled in the art, and we therefore do not wish to be limited to the details shown and described herein but intend to cover all such changes and modifications as are encompassed by the scope of the appended claims.

## Claims

1. An electronic device, comprising:
a first substrate (5, 7; 27, 29) having a first component (21) mounted thereon;
a second substrate (19) having a second component (33) mounted thereon; and
a lead frame connector (1; 31) for connecting the first and second substrates (5, 7; 27, 29; 19), one end of the lead frame connector (1; 31) being formed in a T shape having first and second joint pieces (2a, 2b) mutually protruding in opposite directions;
**characterised in that** the first joint piece (2a) is joined by ultrasonic joining with a first electrode pad provided on the first substrate (5, 7; 27, 29), the second joint piece (2b) is joined by ultrasonic joining with a third electrode pad provided separately from the first electrode pad on the first substrate (5, 7; 27, 29), and the other end of the lead frame connector (1; 31) is joined by soldering or press-fit connection with a second electrode pad provided on the second substrate (19), thereby connecting the first and second substrates (5, 7; 27, 29; 19) by means of the lead frame connector (1; 31).

2. The device of claim 1, wherein the first component (21) is a high heat generation component and the second component (33) is a low heat generation component.

3. The device of claim 1, wherein the first and second substrates (5, 7; 27, 29; 19) are arranged so that the component-mounted sides thereof face each other.

4. The device of claim 1, wherein the first substrate (5, 7; 27, 29) is a metal base substrate and the second substrate (19) is a resin substrate.

5. The device of claim 1, wherein the first and second joint pieces (2a, 2b) of the T-shaped one end of the lead frame connector (1; 31) are ultrasonically joined to the first and third electrode pads with an aluminum foil (13) sandwiched therebetween.

6. The device of claim 5, wherein both the lead frame connector (1; 31) and the first and third electrode pads are made of copper.

7. The device of claim 1, wherein each of the first and second joint pieces (2a, 2b) is split into plural sub-pieces.

8. A method for manufacturing the device of claim 1, in which a step of ultrasonically joining the second joint piece (2b) with the third electrode pad is performed after a step of ultrasonically joining the first joint piece (2a) with the first electrode pad.

9. A method for manufacturing the device of claim 1, in which a step of ultrasonically joining the second joint piece (2b) with the third electrode pad is performed simultaneously with a step of ultrasonically joining the first joint piece (2a) with the first electrode pad.

## Patentansprüche

1. Elektronikvorrichtung mit
einem ersten Substrat (5, 7; 27, 29) mit einer darauf befestigten ersten Komponente (21),
einem zweiten Substrat (19), auf dem eine zweite Komponente (33) befestigt ist, und
einem Leitungsrahmen-Verbindungselement (1; 31) zum Verbinden des ersten und des zweiten Substrats (5, 7; 27, 29; 19), wobei ein Ende des Leitungsrahmen-Verbindungselements (1; 31) eine T-Form hat, bei der ein erstes und ein zweites Verbindungsstück (2a, 2b) in entgegengesetzte Richtungen hervorstehen,
**dadurch gekennzeichnet, dass** das erste Verbindungsstück (2a) durch Ultraschallverbindung mit einem auf dem ersten Substrat (5, 7; 27, 29) vorgesehenen ersten Elektrodenanschluss verbunden ist, das zweite Verbindungsstück (2b) durch Ultraschallverbindung mit einem dritten Elektrodenanschluss verbunden ist, der separat von dem ersten Elektrodenanschluss auf dem ersten Substrat (5, 7; 27, 29) vorgesehen ist, und das andere Ende des Leitungsrahmen-Verbindungselements (1; 31) durch Löten oder eine Presspassungsverbindung mit einem auf dem zweiten Substrat (19) vorgesehenen zweiten Elektrodenanschluss verbunden ist, wodurch das erste und das zweite Substrat (5, 7; 27, 29; 19) über das Leitungsrahmen-Verbindungselement (1; 31) verbunden sind.

2. Vorrichtung nach Anspruch 1, wobei die erste Komponente (21) eine stark wärmeerzeugende Komponente und die zweite Komponente (33) eine schwach wärmeerzeugende Komponente ist.

3. Vorrichtung nach Anspruch 1, wobei das erste und das zweite Substrat (5, 7; 27, 29; 19) so angeordnet sind, dass deren zur Befestigung von Komponenten vorgesehen Seiten einander zugewandt sind.

4. Vorrichtung nach Anspruch 1, wobei das erste Substrat (5, 7; 27, 29) ein Metall-Basis-Substrat und das zweite Substrat (19) ein Harzsubstrat ist.

5. Vorrichtung nach Anspruch 1, wobei das erste und das zweite Verbindungsstück (2a, 2b) des T-förmigen einen Endes des Leitungsrahmen-Verbindungselements (1; 31) mit dem ersten und dem dritten Elektrodenanschluss ultraschallverbunden sind, wobei eine Aluminiumfolie (13) zwischengeschoben ist.

6. Vorrichtung nach Anspruch 5, wobei sowohl das Leitungsrahmen-Verbindungselement (1; 31) als auch der erste und der zweite Elektrodenanschluss aus Kupfer hergestellt sind.

7. Vorrichtung nach Anspruch 1, wobei das erste und das zweite Verbindungsstück (2a, 2b) in mehrere Teilstücke unterteilt sind.

8. Verfahren zur Herstellung der Vorrichtung nach Anspruch 1, in dem ein Schritt zur Ultraschallverbindung des zweiten Verbindungsstücks (2b) mit dem dritten Elektrodenanschluss durchgeführt wird, nachdem ein Schritt zur Ultraschall-Verbindung des ersten Verbindungsstücks (2a) mit dem ersten Elektrodenanschluss durchgeführt wurde.

9. Verfahren zur Herstellung der Vorrichtung nach Anspruch 1, in dem ein Schritt zur Ultraschallverbindung des zweiten Verbindungsstücks (2b) mit dem dritten Elektrodenanschluss gleichzeitig mit einem Schritt zur Ultraschall-Verbindung des ersten Verbindungsstücks (2a) mit dem ersten Elektrodenanschluss durchgeführt wird.

## Revendications

1. Dispositif électronique comportant :
un premier substrat (5, 7 ; 27, 29) ayant un premier composant (21) monté sur lui,
un second substrat (19) ayant un second composant (33) monté sur lui, et
un connecteur de grille de connexion (1 ; 31) qui relie les premier et second substrats (5, 7 ; 27, 29 ; 19), une extrémité du connecteur de grille de connexion (1 ; 31) étant en forme de T ayant des premier et second éléments de liaison (2a, 2b) faisant mutuellement saillie dans des directions opposées,
**caractérisé en ce que** le premier élément de liaison (2a) est relié par soudure à ultrasons avec un premier plot d'électrode agencé sur le premier substrat (5, 7 ; 27, 29), le second élément de liaison (2b) est relié par soudure à ultrasons avec un troisième plot d'électrode agencé séparément du premier plot d'électrode sur le premier substrat (5, 7 ; 27, 29), et l'autre extrémité du connecteur de grille de connexion (1 ; 31) est reliée par soudure ou ajustement serré à un second plot d'électrode agencé sur le second substrat (19), de manière à relier les premier et second substrats (5, 7 ; 27, 29 ; 19) par l'intermédiaire du connecteur de grille de connexion (1 ; 31).

2. Dispositif selon la revendication 1, dans lequel le premier composant (21) est un composant à génération de chaleur élevée et le second composant est un composant à génération de chaleur faible.

3. Dispositif selon la revendication 1, dans lequel les premier et second substrats (5, 7 ; 27, 29 ; 19) sont agencés de sorte que leurs côtés avec les composants montés se font face.

4. Dispositif selon la revendication 1, dans lequel le premier substrat (5, 7 ; 27, 29) est un substrat de base en métal et le second substrat (19) est un substrat en résine.

5. Dispositif selon la revendication 1, dans lequel les premier et second éléments de liaison (2a, 2b) de l'extrémité en forme de T du connecteur de grille de connexion (1 ; 31) sont soudés par ultrasons aux premier et troisième plots d'électrode avec une feuille d'aluminium (13) enserrée entre eux.

6. Dispositif selon la revendication 5, dans lequel le connecteur de grille de connexion (1 ; 31) et les premier et troisième plots d'électrode sont constitués de cuivre.

7. Dispositif selon la revendication 5, dans lequel les premier et second éléments de liaison (2a, 2b) sont divisés en une pluralité de sous-éléments.

8. Procédé de fabrication du dispositif selon la revendication 1, dans lequel une étape de soudure à ultrasons du second élément de liaison (2b) avec le troisième plot d'électrode est exécutée après une étape de soudure à ultrasons du premier élément de liaison (2a) avec le premier plot d'électrode.

9. Procédé de fabrication du dispositif selon la revendication 1, dans lequel une étape de soudure à ultrasons du second élément de liaison (2b) avec le troisième plot d'électrode est exécutée simultanément avec une étape de soudure à ultrasons du premier élément de liaison (2a) avec le premier plot d'électrode.
